# EUROPEAN PATENT APPLICATION

(11) **EP 1 496 552 A2**
(43) Date of publication of application: **12.01.2005**
(21) Application number: 04254088.0
(22) Date of filing: 08.07.2004
(51) Int. Cl.: H01L 33/00, H01L 29/43

(54) **Electrode layer, light generating device including the same and method of forming the same**

(30) Priority: 09.07.2003 KR 2003046325
(71) Applicant: Samsung Electronics Co., Ltd., Suwon-si, Gyeonggi-do (KR)
(72) Inventor: Kwak, Joon-Seop, 301-1101 Sinyeongtong, Hwaseong-si Gyeonggi-do (KR); Nam, Ok-Hyun, 106-504 Pureum Maeul Apt., Seoul (KR)
(74) Representative: Greene, Simon Kenneth

(57) **Abstract**

Provided is an electrode layer for a light generating device, and a method of forming the same and a light generating device including the same. The electrode layer contains a solid solution of an oxide which contains a lanthanide and a metal element. The electrode layer may further contain at least one selected from the group consisting of gold (Au) , gold-lanthanum (AuLa) compound and lanthanum-gallium (LaGa) compound.

## Description

The present invention relates to a material layer and a method of forming the material layer, and more particularly, to an electrode layer and a method of forming the same and a light generating device including the electrode layer.

It is preferable that a light generating device such as a light emitting diode (LED) or a laser diode (LD) has low operating voltage. It is also preferable that high emission efficiency of light is accomplished at lower operating voltage.

Generally, in order to reduce the operating voltage, a light generating device is widely used. The light generating device has a modified material layer between an electrode layer and an active layer. The modified material layer restricts the width of current inflow from the electrode layer to the active layer of the light generating device. Aa a result, light emits from a restricted region only of the active layer.

However, in order to reduce the operating voltage of the light generating device, it is preferable to reduce resistance of the electrode layer and the modified material layer between the electrode layer and the active layer. Since the current to generate light passes through the electrode layer and the electrode layer makes an ohmic contact with a compound semiconductor layer, such as a p-type GaN group, therefore, it is very important to reduce the resistance of the electrode layer in order to reduce the operating voltage of the light generating device.

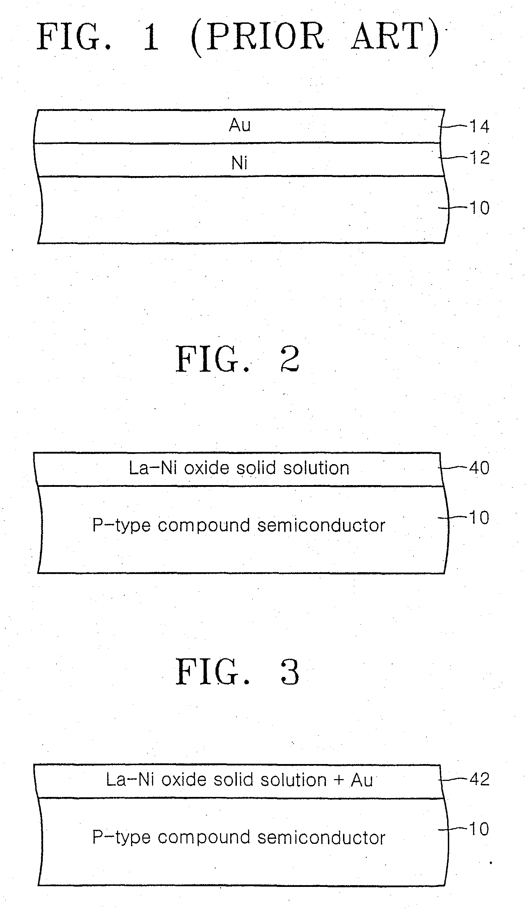

FIG. 1 shows a cross-sectional view of a conventional electrode layer. Referring to FIG. 1, first and second electrode layers 12 and 14 are sequentially formed on a p-type compound semiconductor layer 10. The first and the second electrode layers 12 and 14 are nickel (Ni) and gold (Au), respectively.

In this case, due to the high resistance and low permeability rate of the electrode layer, the electrode layer has limited applicability to LED.

According to an aspect of the present invention, there is provided an electrode layer containing a solid solution of an oxide in which a lanthanide and a metal element are combined.

The present invention aims to provide an electrode layer having low resistance and high permeability rate.

According to the embodiment of the present invention, gold is further included in the electrode layer.

According to another embodiment of the present invention, at least either a gold-lanthanum compound or a lanthanum-gallium compound can be further included in the electrode layer.

The present invention also provides a light generating device comprising the electrode layer.

The present invention also provides a method of manufacturing the electrode layer.

According to an aspect of the present invention, an electrode layer comprising a first electrode layer and a second electrode layer sequentially formed on a compound semiconductor, wherein the first electrode layer may be a compound layer containing a lanthanide element and a first metal element.

The first metal element is nickel (Ni). The second electrode layer is a metal layer or a transparent oxide layer having conductivity. The metal layer is one selected from the group consisting of an Au layer, Pd layer, Pt layer, and Ru layer, and the oxide layer is one selected from the group consisting of a RuO₂ layer, an IrO₂ layer, and an ITO layer.

According to another aspect of the present invention, for a light generating device having at least an n-type compound semiconductor layer, an active layer and a p-type compound semiconductor layer interposed between the n-type and the p-type electrode layers, the p-type electrode layer includes a solid solution layer of an oxide in which a lanthanide element and a metal element are combined.

The p-type electrode layer- may further include either Au or a compound of AuLa and LaGa.

According to further an aspect of the present invention, for a light generating device having at least an n-type compound semiconductor layer, an active layer and a p-type compound semiconductor layer interposed between the n-type electrode layer and the p-type electrode layer. The p-type electrode layer comprises a first electrode layer and a second electrode layer sequentially formed, wherein the first electrode layer may include a compound layer formed of a lanthanide and a first metal element.

Here, the metal layer is one selected from the group consisting of an Au layer, Pd layer, Pt layer, and Ru layer, and the oxide layer is one selected from the group consisting of a RuO₂ layer, IrO₂ layer, and ITO layer.

According to another aspect of the present invention, a method of forming an electrode layer comprises steps of: forming a first electrode layer on a compound semiconductor layer, wherein the first electrode layer is a compound layer of a lanthanoid element and a first metal element; forming a second electrode layer on the first electrode layer; and annealing a product an which the second electrode layer is formed.

Here, the first metal element is Ni, and the second electrode layer is formed of a metal layer or a transparent oxide layer having conductivity. In this case, the metal layer is one selected from the group consisting of an Au layer, Pd layer, Pt layer, and Ru layer, and the oxide layer is one selected from the group consisting of a RuO₂ layer, IrO₂ layer, and ITO layer.

The annealing is performed under an air at atmospheric pressure in a temperature range of 300°C ∼ 700°C, preferably 400°C ∼ 600°C, more preferably 550°C, for 10 seconds to 5 minutes, preferably for 1 minute.

An electrode layer manufactured according to the present invention has low resistance and high permeability rate. Therefore, the use of the electrode layer in a light generating device can reduce the operation voltage and enhance the transmission rate of the LED. As a consequence, the light emiting efficiency of the light generating device can be significantly improved over a conventional LED.
FIG. 1 is a cross-sectional view of a conventional electrode layer;
FIGS. 2 through 5 are cross-sectional views of an electrode layer according to embodiments 1 through 4 of the present invention;
FIG. 6 is a graph showing current-voltage characteristics of an electrode layer according to an embodiment of the present invention;
FIG. 7 is a graph showing current-voltage characteristics of an electrode layer according to an embodiment of the present invention and an electrode layer according to the prior art;
FIG. 8 is a graph showing variations of wavelength vs. permeability of an electrode layer according to an embodiment of the present invention and an electrode layer according to the prior art;
FIGS.9 through 11 are cross-sectional views of a light generating device equipped with an electrode layer according to embodiments 1 through 3 of the present invention; and
FIG. 12 is a cross-sectional view showing steps of manufacturing an electrode layer according to the present invention.

Hereinafter, an electrode layer, a light generating device including the electrode layer according to the present invention, and a method of manufacturing the electrode layer according to the present invention will be described with reference to the appended drawings.

### Embodiment 1

Referring to FIG. 2, a first electrode layer 40 is formed on a p-type compound semiconductor layer 10. The p-type compound semiconductor layer 10 is a p-type group III-V nitride semiconductor layer, but preferably, the p-type compound semiconductor layer 10 may be a p-type GaN layer. The first electrode layer 40 is a solid solution layer of an oxide containing at least a lanthanide such as La and a predetermined metal such as Ni (hereinafter, lanthanum-nickel oxide (LaₓNi_{Y}O_{Z}) solid solution layer). The lanthanum-nickel oxide solid solution layer is, for example, La₂NiO₄ or LaNiO₃.

### Embodiment 2

Referring to FIG. 3, a second electrode layer 42 is formed on the p-type compound semiconductor layer 10. The second electrode layer 42 may be the first elelctrode layer 40 containing a predetermined metal. For example, the second electrode layer 42 may be the lanthanum-nickel oxide solid solution layer further comprising Au.

However, instead of gold (Au), the lanthanum-nickel oxide solid solution layer may further comprise one selected from the group consisting of Pt, Pd, Ru, Ir, and Ag.

### Embodiment 3

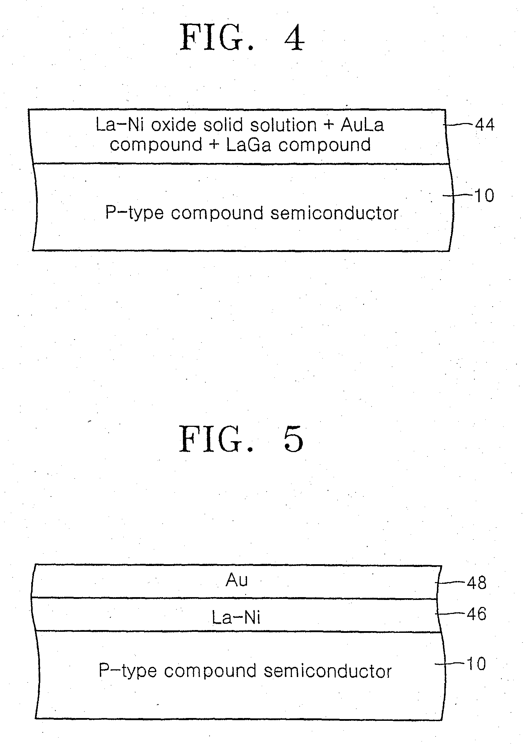

Referring to FIG. 4, a third electrode layer 44 is formed on the p-type compound semiconductor layer 10. The third electrode layer 44 is formed by adding a predetermined compound to the first electrode layer 40. For example, the third electrode layer 44 can be formed by adding a first lanthanum compound containing gold and a second lanthanum compound containing gallium to the lanthanum-nickel oxide solid solution layer. In this case, the first lanthanum compound is a compound such as LaAu comprising a lanthanide such as lanthanum. The second lanthanum compound is a compound such as LaGa comprising a lanthanide such as lanthanum.

### Embodiment 4

Contrary to the embodiments 1 through 3, an electrode layer formed according to embodiment 4 of the present invention depicted in FIG. 5, may be a multi-layer. More specifically, referring to FIG. 5, a fourth electrode layer 46 is formed on the p-type compound semiconductor layer 10, and, a fifth electrode layer 48 is formed on the fourth electrode layer 46.

The fourth electrode layer 46 is a lanthanoid such as lanthanum and a predetermined metal such as a compound containing nickel. The fifth electrode layer 48 is either a predetermined metal layer or a transparent oxide having conductivity. In this case, the metal layers are preferably gold layers, however, it may be other metal layers such as one selected from the group consisting of Pt, Pd, Ru, Ir, and Ag layer. The transparent oxide layer having conductivity is one selected from the group consisting of a ruthenium (RuO2) film, an iridium (IrO2) film, and an indium tin oxide (ITO) film.

Hereinafter, experiments for the resistance and permeability characteristics of the electrode layer formed according to embodiments of the present invention will be described.

### {First Experiment : resistance characteristic test}

In the first experiment, to form an electrode layer an 8 nm thick lanthanum-nickel compound layer was formed on a p-type GaN layer, and an 8 nm thick of gold layer was formed on the lanthanum-nickel compound.

The resistance characteristic of the electrode layer thus formed was tested in four cases, using an indirect method by measuring a current vs. voltage characteristic of the electrode layer.

In a first case, the current vs. voltage characteristic of the electrode layer was measured right after the formation of the electrode layer.

In a second case, the current vs. voltage characteristic of the electrode layer was measured after annealing the electrode layer for a predetermined time at a temperature of 350 °C.

In a third and a fourth cases, the current vs. voltage characteristics of the electrode layer were measured after annealing the electrode layer for a predetermined time at a temperature of 450°C and a temperature of 550°C, respectively.

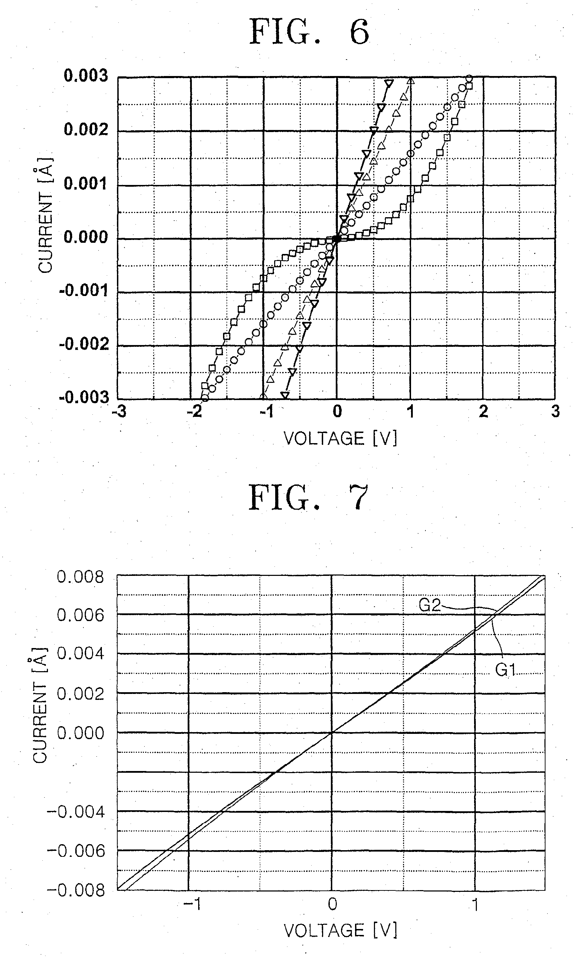

FIG. 6 shows the test results for case 1 (symbol ■), case 2 (symbols •), case 3 (symbol▲), and case 4 (symbol▼).

Referring to FIG. 6, the slope of the graphs increases from case 1 to case 4. This means that as the temperature increases, a current flow through the respective electrode layer increase, i.e., a resistance of the respective electrode layer decreases.

FIG. 7 shows the comparison of the resistance characteristics of the electrode layer according to the present invention G2 and that of the conventional art G1.

For the first experiment, the electrode layer according to the present invention was a multi-layer sequentially formed of a 5 nm thick lanthanum-nickel compound layer and a 5 nm thick gold layer, and the conventional electrode layer was a multi-layer sequentially formed of a 5 nm thick nickel layer and a 5 nm thick gold layer.

In both cases of the first experiment, the test (experiment case 1) was conducted at atmospheric pressure at a temperature of 500°C for 1 minute.

Referring to the graph G1 and graph G2 in FIG. 7, a current measured at an arbitrary voltage level of the electrode layer of the present invention is always larger than that of the conventional art. This means that the resistance of the electrode layer of the present invention is always lower than that of the conventional art.

### {Second Experiment : Permeability characteristic test}

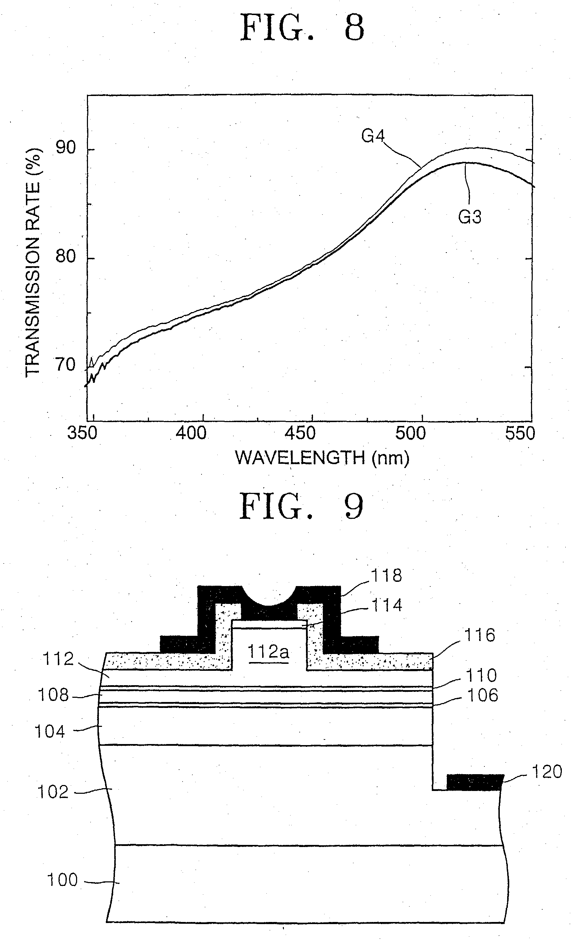

After that, the second experiment was conducted in order to compare the permeability of the two electrode layers of the present invention and the conventional art. The test result is showing in FIG. 8. In FIG. 8, the graph 3 representing by symbol G3 indicates the test result of experiment case 2 of the electrode layer of the conventional art, and the graph 4 representing by symbol G4 indicates the test result of experiment case 2 of the electrode layer of the present invention.

In the second experiment, an electrode layer according to the present invention was formed by sequentially placing a 5 nm thick lanthanum-nickel compound layer and a 4 nm thick gold layer on a p-type GaN layer. Also, an electrode layer according to the conventional art was formed by sequentially placing a 5 nm of nickel layer and a 4 nm of gold layer on the p-type GaN layer.

The electrode layers according to the present invention and the conventional art were annealed at atmospheric pressure at a temperature of 550°C for 1 minute, afterward, the permeability of the electrode layers was conducted. For the second experiment, light in the visible range was used for the permeability characteristic test.

Referring to the graph G3 and graph G4 in FIG. 8, the permeability of the electrode layer of the present invention is always higher than that of the conventional art for all light sources.

The experimental results showed that the resistance and permeability characteristics of the electrode layer of the present invention are superior to that of the electrode layer of the conventional art. Accordingly, if the electrode layer of the present invention is used in a light generating device, such as a LED or a LD, an operating voltage of the light generating device can be decreased, while an amount of light can be increased, thereby, increasing the light emission efficiency of the light generating device.

The following is a description of a laser diode (LD), as an example of light generating device, having an electrode layer according to the present invention, FIG. 9 shows a LD having p-type and n-type electrode layers formed in a same direction.

Referring to FIG. 9, a first n-type compound semiconductor layer 102 such as an n-type GaN layer is formed on a sapphire substrate 100. An n-type electrode layer 120 is formed on a predetermined area of the first n-type compound semiconductor layer 102. The rest of the area of the first n-type compound semiconductor layer 102 projects upward. A second n-type compound semiconductor layer 104 is positioned on the projected area of the first n-type compound semiconductor layer 102. An n-type waveguide layer 106, for example, an n-type GaN layer which has higher refractive index than the second n-type compound semiconductor layer104, an active layer (InGaN) 108 which has higher refractive index than the n-type waveguide layer 106, and a p-type waveguide layer 110, for example, a p-GaN layer which has lower refractive index than the active layer 108 are stacked sequentially on the n-type compound semiconductor layer 104. A first p-type compound semiconductor layer 112, such as p-AlGaN/GaN layer which has lower refractive index than p-type waveguide layer 110, is formed on the p-type waveguide layer 110. A ridge unit 112a is located in the middle area of the first p-type compound semiconductor layer 112. A second p-type compound semiconductor layer 114, such as a p-type GaN layer is formed on the ridge unit 112a of the first p-type compound semiconductor layer 112. The ridge unit 112a is completely covered by a protective layer 116. The protective layer 116 partly contacts the second p-type compound semiconductor layer 114. A p-type electrode layer 118 is formed in contact with an exposed surface of the second p-type compound semiconductor layer 114 on the protective layer 116. The p-type electrode layer is one of the electrodes depicted in FIGS. 2 through 5.

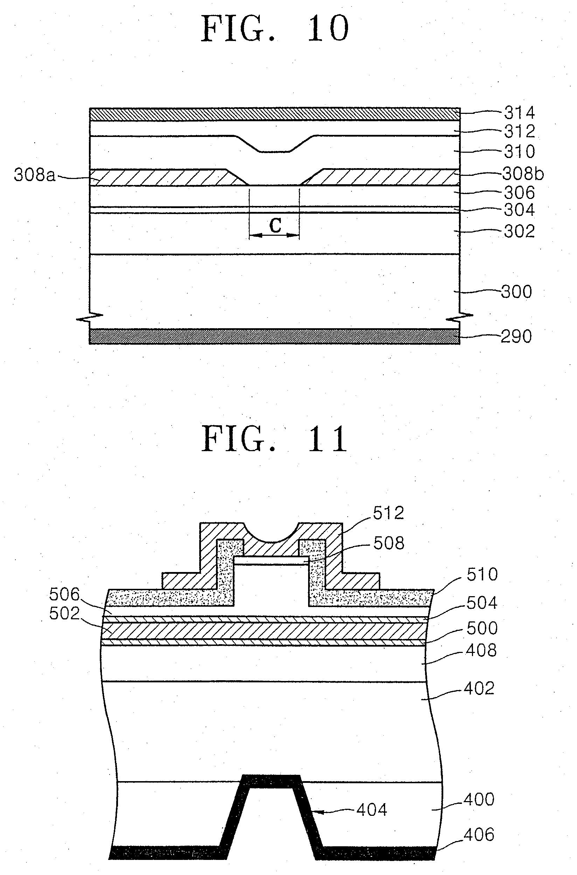

FIG. 10 shows a LD having an n-type and a p-type electrode layer facing each other.

Referring to FIG. 10, a substrate 300 is placed on an n-type electrode 290. The substrate 300 is an n-type compound semiconductor layer, preferably an n-type GaN layer. On the substrate 300, an n-type clad layer 302, an active layer 304 having a multi-quantum well (MQW) structure and generating laser beam, and a p-type first clad layer 306 are stacked sequentially. The n-type clad layer 302 is an n-type compound layer semiconductor, for example, an n-AlGaN layer, which has lower refractive index than the active layer 304. The p-type first clad layer 306 is a p-type compound semiconductor layer which has lower refractive index than active layer 304, for example, p-InAlGaN layer. The active layer 304, the n-type clad layer 302, and the p-type first clad layer 306 form a resonance layer for laser emission. A first current blocking layer 308a and a second 308b current blocking layer are formed on the p-type clad layer 306. The first and second current blocking layers 308a and 308b are apart from each other at a predetermined distance on the order of C. Between the first and second current blocking layers 308a and 308b, current for launching a laser can pass through, but in other areas, current is blocked. The distance C between the first and the second current blocking layers 308a and 308b defines a width of a channel region for current flow.

A p-type second clad layer 310 is formed on the first and the second blocking layers and the p-type first clad layer 306. The second clad layer 310 contacts the p-type first clad layer 306 through the channel region formed by the first and the second blocking layers 308a and 308b. The p-type first and second clad layers 306 and 310 are p-type compound semiconductor layers. A p-type compound semiconductor layer 312 having a flat surface and used as contacting layer is formed on the p-type second clad layer 310. The p-type compound semiconductor layer 312 is preferably a p-GaN layer. A p-type electrode layer by ohmic contact is formed on the p-type compound semiconductor layer 312. The p-type electrode layer 314 is one of the electrode layers depicted in FIGS. 2 through 5.

FIG. 11 is a cross-sectional view of a laser diode (LD) having an n-type electrode layer and a p-type electrode layer facing each other, which has a different configuration from the electrode layer in FIG. 10.

Referring to FIG. 11, an n-type compound semiconductor layer 402 is formed on a high resistance substrate 400, such as a sapphire substrate. The n-type compound semiconductor layer 402 is a group III-V nitride semiconductor layer based on GaN group, preferably a transformed form, more preferably an n-GaN layer. A via hole 404 opening downward is formed on the high resistance substrate 400. A portion of a lower surface of the n-type compound semiconductor layer 402 is exposed by the via hole 404. A conductive layer 406, which is in contact with the n-type compound semiconductor layer 402 through the exposed portion of the via hole 404, is formed on the lower surface of high resistance substrate 400. The conductive layer 406 is used as n-type electrode layer. An n-type clad layer 408 is formed on the n-type compound semiconductor layer 402. The first waveguide layer 500, the active layer 502, and the second waveguide layer 504 are stacked sequentially forming a resonance layer On the n-type clad layer 408. The first and the second waveguide layers 500 and 504 are group III-V nitride compound semiconductor layers, preferably, an n-GaN layer and a p-GaN layer, respectively. An active layer 502 is a group III-V nitride compound semiconductor layer, for example, InGaN layer which contains a certain proportion of indium. The refractive index of active layer 502 is higher than that of the first and the second waveguide layer 500 and 504. A p-type clad layer 506 is formed on the second wave-guide layer 504. The center of an upper part of the p-type clad layer 506 forms a projection. A p-type compound semiconductor layer 508 is placed on the central projection of the p-type clad layer 506. The p-type compound semiconductor layer 508 is preferably a p-GaN layer. A protective layer 510 covers the entire surface of the p-type clad layer 506, and the protective layer is in contact with the both lateral of the p-type compound semiconductor layer 508. A p-type electrode layer 512 is formed on the protective layer 510 to be in contact with the p-type compound semiconductor layer 508 in the exposed area. Here, the p-type electrode layer 512 one of the electrode layers depicted in FIGS. 2 through 5, but preferably one of the electrode layers depicted in FIGS. 2 through 4.

Hereinafter, a method of manufacturing an electrode layer according to the present invention will be described.

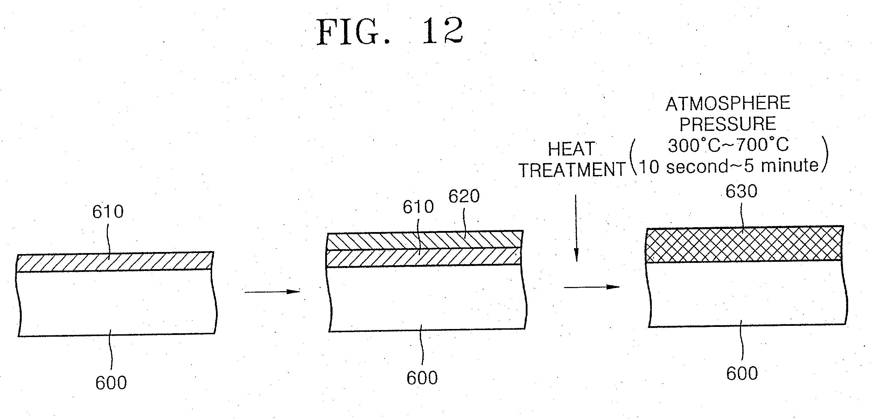

Referring to FIG. 12, firstly, a first electrode layer 610 is formed on a p-type compound semiconductor layer 600 such as p-type GaN layer. The first electrode layer 610 is a compound layer of LaNi, containing at least a lanthanide such as lanthanum, and a predetermined metal such as Ni. Here, the first electrode layer 610 is formed with a thickness of 1Å∼10,000Å.

After the first electrode layer 610 is formed, a second electrode layer 620 is formed on the first electrode layer 610, with a thickness of 1Å∼50,000Å. Preferably, the second electrode layer is formed of a metal layer, but it may also be a transparent oxide layer having conductivity. Here, when the second electrode layer 620 is formed of the metal layer, it is preferable that the second layer 620 is formed of a gold layer but it may be formed of other metal layer such as one selected from the group consisting of palladium layer, platinum layer, and ruthenium layer. Also, when the second electrode layer 620 is formed of the transparent oxide layer having conductivity, the second electrode layer 620 can be formed of a ruthenium oxide film or an iridium oxide film.

After the formation of the second electrode layer 620, the resultant structure is heated under an air at atmospheric pressure. The temperature of the heat treatment is in a range of 300°C∼700°C, preferably, 400°C∼600°C, more preferably, 550°C, for 10 seconds to 5 minutes, preferably for about 1 minute.

In the course of heat treatment, some components comprising the first and the second electrode layers 610 and 620 are oxidized, for example, the components of the first electrode layer 610, by intermixing with each other. This results in the formation of a single electrode layer 630 on the p-type compound semiconductor layer 600. This single electrode layer 630 is an oxide solid solution layer, for example, lanthanum-nickel oxide ( LaₓNi_{Y}O_{Z}) solid solution layer or lanthanum-nickel oxide ( La_{X}Ni_{Y}O_{Z}) solid solution layer containing gold, or lanthanum-nickel oxide solid solution layer which contains a gold-lanthanum compound (AuLa) and a lanthanum-gallium compound (LaGa). The lanthanum-nickel oxide solid solution layer may be La₂NiO₄ or LaNiO₃.

On the other hand, the method of manufacturing the electrode layer can readily apply for manufacturing a light generating device as depicted in FIGS 9 through 11.

As it can be seen from the embodiments and experiments of the present invention, the electrode layer formed according to the present invention has higher permeability and lower resistance than the conventional electrode layers. Accordingly, if the electrode layer of the present invention is included in a light generating device, an operating voltage of the light generating device decreases while permeability increases, therefore, the emission efficiency of the light generating device notably increases than that of the light generating device in the conventional art.

While the present invention has been particularly shown and described with reference to embodiments thereof, it should not be construed as being limited to the embodiments set forth herein. For example, one skilled in this art could apply the electrode layer of the present invention to the light generating device as depicted in FIGS. 9 through 11 or other light generating device, and even to other devices which requires a low resistance electrode layer. Therefore, the scope of the present invention shall be defined by the appended claims set forth herein.

## Claims

1. An electrode layer comprising a solid solution of an oxide in which a lanthanide and a metal element are combined.

2. The electrode layer of claim 1, further comprising gold.

3. The electrode layer of claim 1 or 2, further comprising at least one of a gold lanthanum compound (AuLa) and a lanthanum-gallium compound (LaGa).

4. The electrode layer of any preceding claim, wherein the metal element is nickel.

5. An electrode layer according to claim 1, comprising a first electrode layer and a second electrode layer sequentially deposited on a compound semiconductor, wherein the first electrode layer comprises the solid solution of an oxide in which a lanthanide and a first metal element are combined.

6. An electrode layer comprising a first electrode layer and a second electrode layer sequentially deposited on a compound semiconductor, wherein the first electrode layer is a compound layer containing a lanthanide and a first metal element.

7. The electrode layer of claim 5 or 6, wherein the first metal element is nickel.

8. The electrode layer of claim 5, 6 or 7, wherein the second electrode layer is a metal layer.

9. The electrode layer of claim 8, wherein the second electrode metal layer is a gold layer, a palladium layer, a platinum layer, or a ruthenium layer.

10. The electrode layer of claim 5, 6 or 7, wherein the second electrode layer is a transparent oxide layer having conductivity.

11. The electrode layer of claim 10, wherein the second electrode oxide layer is a RuO₂ layer, an IrO₂ layer, or an ITO layer.

12. A light generating device comprising at least an n-type compound semiconductor layer, an active layer, and a p-type compound semiconductor layer formed between an n-type and a p-type electrode layer, wherein the p-type electrode layer is an electrode layer according to any of claims 1 to 11.

13. A method of forming an electrode layer comprises steps of:
forming a first electrode layer on a compound semiconductor layer;
forming a second electrode layer on the first electrode layer; and
annealing a product on which the second electrode layer is formed,
wherein the first electrode layer is a compound layer formed of a lanthanide and a first metal element.

14. The method of claim 13, wherein the first metal is nickel.

15. The method of claim 13 or 14, wherein the second electrode layer is a metal layer.

16. The method of claim 15, wherein the metal layer is a layer selected from the group consisting of a gold layer, a palladium layer, a platinum layer, and a ruthenium layer.

17. The method of claim 13 or 14, wherein the second electrode layer is a transparent oxide layer having conductivity.

18. The method of claim 17, wherein the oxide layer is a layer selected from the group consisting of a RuO₂ layer, an IrO₂ layer, and an ITO layer.

19. The method of any of claims 12 to 18, wherein the electrode layer is annealed under an air at atmospheric pressure, in a temperature range of 300°C∼700°C for 10 seconds ∼ 5 minutes.
